# EUROPEAN PATENT APPLICATION

(11) **EP 1 176 000 A1**
(43) Date of publication of application: **30.01.2002**
(21) Application number: 01908230.4
(22) Date of filing: 02.03.2001
(51) Int. Cl.: B32B 15/08

(54) **CARRIER FOIL-PASTED METAL FOIL AND PRODUCTION METHOD THEREOF**

(30) Priority: 03.03.2000 JP 2000058613
(71) Applicant: Mitsui Mining & Smelting Co., Ltd., Tokyo 141-8584 (JP)
(72) Inventor: OBATA, Shinichi, MITSUI MINING SMELTING CO. LTD., Ageo-shi, Saitama 362-0021 (JP); DOBASHI, Makoto, MITSUI MINING SMELTING CO. LTD., Ageo-shi, Saitama 362-0021 (JP); KATAOKA, Takashi, MITSUI MINING SMELTING CO. LTD., Ageo-shi, Saitama 362-0013 (JP)
(74) Representative: Setna, Rohan P.
(86) International application number: JP0101601
(87) International publication number: WO0164433

(57) **Abstract**

An object of the present invention is to provide a technology for preventing wrinkles on metal foils such as nickel, tin, cobalt, chromium and iron from being generated in order to facilitate their handling. The object is accomplished by using a carrier foil manufactured by bonding a carrier foil layer with a metal foil layer via an organic adhesive interface layer, wherein a metal foil layer comprising one of nickel, tin, cobalt, chromium, lead, iron and zinc, or an alloy as a combination of two or more of them or an alloy of them is used for the metal foil with carrier.

## Description

### FIELD OF THE INVENTION

The present invention relates to a metal foil with carrier and to a method for manufacturing the same.

### DESCRIPTION OF THE RELATED ART

An electrodeposited copper foil with carrier has been widely used in application fields using a copper clad laminate which is prepared by peeling a carrier foil of the electrodeposited copper foil with carrier after hot-pressing it on a substrate.

The inventors of the present invention have proposed using an electrodeposited copper foil with carrier manufactured by forming an adhesive interface layer between the carrier foil layer and electrodeposited copper foil layer using an organic chemical. This type of electrodeposited copper foil with carrier has a feature that the peeling strength of the adhesive interlayer is stabilized at a low level to enable the carrier foil to be easily peeled off.

The carrier foil of the electrodeposited copper foil with carrier prevents the electrodeposited copper foil from being wrinkled during handling of the electrodeposited copper foil, which also serves as a foil for protecting the surface of the electrodeposited copper foil from being contaminated. Usually, a very thin electrodeposited copper foil has been used for the purpose above.

It has been a problem for many years to provide a method for preventing the copper foil, as well as films to be used as foils, from being wrinkled during handling of the foils. For example, handling of gold foil that is used for traditional craft articles such as Buddhist altar ogjects requires close attention and a high degree of skill in handling the foil, since the gold foil is manufactured, for example, by beating one gram of gold into a foil with an area corresponding to about one "tatami (a straw mat)", i.e. about 2m².

However, generation of wrinkles during handling can be prevented when metal foils such as a nickel, tin, cobalt, chromium, and iron foil are processed like the electrodeposited copper foil with carrier.

### BRIEF DESCRIPTION OF THE DRAWINGS

Fig. 1 illustrates a schematic cross section of a metal foil with carrier.
Fig. 2 illustrates a schematic cross section of an apparatus for forming a metal foil with carrier.
Fig. 3 illustrates a schematic cross section of another metal foil with carrier.
Fig. 4 illustrates a schematic cross section of another apparatus for forming a metal foil with carrier.

### SUMMARY OF THE INVENTION

Accordingly, the inventors of the present invention have devised, through intensive studies, a method for easily handling foils of various metals such as copper, nickel, tin, cobalt, chromium and iron, and foils of various alloys, by forming them into metal foils with carrier having organic adhesive interface layers.

In a first aspect, the present invention provides a metal foil with carrier, wherein a carrier foil layer is bonded to a metal foil layer via an organic adhesive interface layer, and wherein the metal foil layer comprises either one of nickel, tin, cobalt, chromium, lead, iron and zinc, or an alloy as a combination of two or more of them.

The metal foil comprising only zinc is not included in the present invention because, according to the studies by the inventors of the present invention, the zinc foil cannot be easily peeled from the carrier foil when the zinc foil with carrier according to the present invention having an organic adhesive interface layer is formed by depositing zinc at a deposition potential region of -900 mV or less to more than -1000 mV as measured at 40°C using a silver chloride-silver saturated electrode as a reference electrode. The metal foil can be easily peeled from the carrier foil, on the contrary, when zinc is deposited as a zinc-nickel alloy at a deposition potential in the region of -900 mV or more. Accordingly, the metal foil with carrier having a zinc layer directly formed on the organic adhesive layer is not included in the metal foil with carrier according to a second aspect of the present invention comprising two layers or more of the metal foils.

These carrier layers can be peeled from the metal foil in any processing steps except those having a metal foil using only zinc. For example, the carrier foil may be peeled either before applying the metal foil or after bonding the metal foil on an object to be coated.

The metal foils with carrier described above may be applied on a flat object to be coated by removing the carrier foil after pressing and adhering the metal foil portion together with the carrier foil on the object to be coated, thereby damage to and contamination of the metal foil before use can be prevented. When the metal foil is applied on an object to be coated having a complex configuration, on the other hand, the carrier foil may be previously removed to use the metal foil as a conventional metal foil.

A tin foil with carrier having a metal foil formed by using tin can be used as a coating member or an anticorrosive of building materials like zinc in the construction business in the same manner as conventional tin foils are used.

A cobalt foil with carrier having a metal foil formed by using cobalt can be used for endowing electrical contact members and tape carrier packages with anti-migration properties.

A chromium foil with carrier having a metal foil formed by using chromium can be used for a substitute of a thick chromium plating film on plastics, a resister foil and an electric heater.

An iron foil with carrier having a metal foil formed by using iron can be used for an electromagnetic wave absorber and a shield member, and for forming the surface of a magnet board.

A lead foil with carrier having a metal foil formed by using lead can be used for a laminated sheet for preventing adhesion of shells on building materials and an antivibration laminate of steel plates. A metal foil with carrier having a lead-tin alloy foil as a combination of lead and tin can be used for a thermo-fuse or current fuse, in particular as a substitute of solders by forming the metal foil layer with a lead-tin alloy.

A nickel foil with carrier having a metal foil layer formed by using nickel can be used for a laminated ceramic capacitor, a flat heating resistor or a resistor circuit for electronic appliances. A metal foil with carrier having a metal foil formed by using a nickel-cobalt alloy can be also used for the same purpose as described above. The metal foil with carrier can be used for magnetic materials of very thin magnets when the metal foil is made of a nickel-cobalt alloy and an iron-nickel-cobalt alloy.

The alloy foil with carrier obtained by an appropriate combination of foregoing elements other than the combinations of the elements as described above can be also effectively utilized as electrical contact materials, electrical resistors, brazing materials, magnetic materials, solid lubricants and shielding materials.

In a second aspect, the present invention provides a metal foil with carrier manufactured by bonding a carrier foil and a metal foil via an organic adhesive interface layer, wherein the metal foil has a layer structure of two or more of nickel, tin, cobalt, chromium, lead, iron and zinc. These metal foils are expected to have various applications such as magnetic shielding materials, wear-resistant surface-coating materials, radiation shielding materials and magnetic films that are expected to have growing uses in very wide industrial fields.

The foil materials that can be used for the carrier foils are not particularly restricted, and metal foils such as an aluminum foil and a copper foil that have been conventionally used, or electroconductive organic films may be used depending on the purpose of use. However, the carrier foil should be a conductive material since the metallic foil is formed by electrodeposition by cathode polarization of the carrier foil itself in a plating solution. Particularly, an object to be coated having a complex configuration can be coated with a metal foil with carrier when a flexible conductive organic film is used for the carrier foil.

It is advantageous to use the following organic agents for forming the organic adhesive interface layer located between the carrier foil and metal foil layer. These organic agents are preferably selected from one or plural agents comprising nitrogen containing organic compounds, sulfur containing organic compounds and carboxylic acids.

Among the nitrogen containing compounds, sulfur containing compounds and carboxylic acids, the nitrogen containing compounds include those having substituent groups. They are preferably triazole compounds containing substituent groups such as 1,2,3-benzotriazole (abbreviated as BTA hereinafter), carboxybenzotriazole (abbreviated as CBTA hereinafter), N,N'-bis(benzotriazorylmethyl)urea (abbreviated as BTD-U hereinafter), 1H-1,2,4-triazole (abbreviated as TA hereinafter) and 3-amino-1H-1,2,4-triazole (abbreviated as ATA hereinafter).

Preferable sulfur containing organic compounds include mercaptobenzothiazole (abbreviated as MTB hereinafter), thiocyanuric acid (abbreviated as TCA hereinafter) and 2-benzimidazole thiol (abbreviated as BIT hereinafter).

Monocarmoxylic acids are preferably used among the carboxylic acids. In particular, oleic acid, linoleic acid and linolenic acid are preferably used.

The method for using the organic agents described above will be described hereinafter together with the method for forming the adhesive interface layer on the carrier foil. The adhesive interface layer may be formed on the carrier foil by dissolving one of the foregoing organic agents in a solvent followed by immersing the carrier foil in the solution, by showering, spraying or dropping the solution on the surface on which the adhesive interface layer is formed, or by electrodeposition. No particularly specified methods are required for forming the adhesive interface layer. The preferable concentration range and temperature range for the solutions of all the organic agents described above are 0.01 g/liter to 10 g/liter and 20 to 60°C, respectively. The concentration of the organic agent solution is not particularly restricted, and a solution having a high or low concentration may be naturally used without any problem.

The adhesive interface layer may be formed using an appropriate combination of the organic agents described above, including repetition of the foregoing methods, in order to enable the thickness of the adhesive interface layer to be controlled with high precision.

The adhesive interface layer is thought to be formed by absorption of the organic agent on the surface of the carrier foil. Accordingly, it may be suggested that the higher concentration of the organic agent enhances absorption of the organic agent on the surface of the carrier foil, and the concentration of the organic agent is basically determined by the speed of the manufacturing line. The time interval for permitting the carrier foil to contact the organic agent dissolved in a solvent may be also determined by the speed of the manufacturing line, and the line speed should be determined based on the practical contact time of 5 to 60 seconds.

As a results of considering the above situation, it is concluded that absorption of the organic agent on the surface of the carrier foil within a short period of time is difficult at a lower limit concentration of the organic agent of lower than 0.01 g/liter. In addition, the thickness of the adhesive interface layer formed turns out to be irregular to make it impossible to stabilize the quality of the product. The absorption rate of the organic agent on the surface of the carrier foil is never increased, on the other hand, in response to the concentration of the organic agent of exceeding an upper limit of 10 g/liter. The higher concentration is also not preferable from the view point of production cost.

Control of quantitative restriction of the organic agent for forming the adhesive interface layer can be relaxed by using the foregoing organic agents, enabling peel strength between the carrier foil and electrodeposited metal foil to be restricted within a given range. Moreover, the adhesive interface layer has an excellent heat resistance that enables stable peel strength to be maintained even after heat-treatment.

These organic agents have not usually been electric conductive materials but have been insulating materials. However, since the carrier foil itself in the metal foil with carrier according to the present invention is used as a cathode for polarization in order to permit a metal to directly electrodeposite on the organic adhesive interface layer formed by using the organic agent on the carrier foil, an electric current should be allowed to flow through the carrier foil via the organic adhesive interface layer. In other words, the adhesive interface layer comprising the organic agent naturally has a limited thickness, or a thickness that can ensure an appropriate peel strength besides enabling stable electrodeposition of a metal.

Accordingly, it is not important how the adhesive interface layer is formed within what period of processing time using what concentration of the organic agent. Instead, the thickness of the resultant thickness of the organic adhesive interface layer, or the amount of the organic agent present on the adhesive interface, is important. The inventors of the present invention have confirmed that the thickness of the adhesive interface layer using the organic agent is preferably within a range of 1 nm to 1 µm.

Proper peel strength as well as stable electrodeposition of the metal can be ensured at the thickness specified in the present invention. In other words, a uniform adhesive interface layer cannot be formed at a thickness of the organic agent to be used for the organic adhesive interface layer of 1 nm as a lower limit, because the thickness of the adhesive interface layer becomes irregular. Consequently, a stable and proper peel strength cannot be obtained so that there is often failure to peel off the carrier foil.

When the thickness of the organic agent exceeds the upper limit of 1 µm, electric current become unstable and deposition of the metal become uneven, thus making it difficult to form an electrodeposited copper foil layer with a uniform thickness. The minimum essential peel strength cannot be satisfied even by depositing the metal for a long period of time. Flowing an electric current is completely impossible when the thickness of the adhesive interface layer is further increased.

The "proper peel strength" as used herein refers to a strength within a range of 1 to 200 gf/cm as measured by following JIS-C-6481. This range lies within a range determined by adding user's ideal demand against the metal foil with carrier to the peel strength at the interface between the carrier foil and electrodeposited metal foil that is considered to be practically appropriate when practical use of conventional electrodeposited metal foil with peelable-type carrier is considered. The peeling work becomes easier as the peel strength at the interface between the carrier foil and electrodeposited copper foil is lower. A peel strength of less than 1 gf/cm will cause defects in the products, on the other hand, such as winding of the metal foil with carrier during the manufacturing step, and swelling and positional shift due to spontaneous partial peeling between the carrier foil and metal foil during the coating step. When the peel strength exceeds 200 gf/cm, a feature of the present invention that the carrier foil can be easily peeled is not feasible, and a measure of using a specialized apparatus is required for peeling off.

The metal foil layer is formed after forming the organic adhesive interface as described above. The metal foil may be formed on the organic adhesive interface by electrodeposition. The following solutions are used in the metal foil forming bath.

A solution that is used for the nickel plating solution may be generally used for forming the nickel foil layer. For example, the nickel plating conditions comprise (1) 5 to 30 g/liter of nickel using nickel sulfate, bath temperature of 20 to 50°C, pH 2 to 4, and current density of 0.3 to 10 A/dm², (2) 5 to 30 g/liter of nickel using nickel sulfate, 50 to 500 g/liter of potassium pyrophospate, bath temperature of 20 to 50°C, pH 8 to 11, and current density of 0.3 to 10 A/dm², and (3) 10 to 70 g/liter of nickel using nickel sulfate, 20 to 60 g/liter of boric acid, bath temperature of 20 to 50°C, pH 2 to 4, and current density of 1 to 50 A/dm², and the other conditions for the conventional Watt's bath.

A solution that is used for the tin plating solution may be generally used for forming the tin foil layer. For example, the tin plating conditions comprise (1) 5 to 30 g/liter of tin using tin(II) sulfate, bath temperature of 20 to 50°C, pH 2 to 4, and current density of 0.3 to 10 A/dm², and (2) 20 to 40 g/liter of tin using tin(II) sulfate, 70 to 150 g/liter of sulfuric acid, bath temperature of 20 to 35°C, 70 to 120 g/liter of cresol sulfonic acid, 1 to 5 g/liter of gelatin, 0.5 to 2 g/liter of beta-naphthol, and current density of 0.3 to 3 A/dm².

A solution that is used for the cobalt plating solution may be generally used for forming the cobalt foil layer. For example, the cobalt plating conditions comprise (1) 5 to 30 g/liter of cobalt using cobalt sulfate, 50 to 500 g/liter of trisodium citrate, bath temperature of 20 to 50°C, pH 2 to 4, and current density of 0.3 to 10 A/dm², (2) 5 to 30 g/liter of cobalt using cobalt sulfate, 50 to 500 g/liter of potassium pyrophosphate, bath temperature of 20 to 50°C, pH 8 to 11, and current density of 3 to 10 A/dm², and (3) 10 to 70 g/liter of cobalt using cobalt sulfate, 20 to 60 g/liter of boric acid, bath temperature of 20 to 50°C, pH 2 to 4, and current density of 1 to 50 A/dm².

A solution that is used for the lead plating solution may be used for forming the lead foil layer. For example, the lead plating condition comprises 250 to 400 g/liter of lead borofluoride, 30 to 50 g/liter of borofuluoric acid, 10 to 30 g/liter of boric acid, 0.1 to 0.5 g/liter of glue, 0.1 to 1.0 g/liter of beta-naphthol, bath temperature of 25 to 50°C, and current density of 1 to 5 A/dm².

A solution that is used for the iron plating solution may be used for forming the iron foil layer. For example, the iron plating condition comprises (1) 10 to 60 g/liter of iron using iron(II) sulfate, bath temperature of 25 to 50°C, pH 2.5 or less, and current density of 1 to 20 A/dm², and (2) 200 to 300 g/liter of iron(II) sulfate, 35 to 50 g/liter of iron(II) chloride, bath temperature of 40 to 60°C, pH 3.5 to 5.5, and current density of 1 to 20 A/dm².

The condition for forming a zinc-nickel alloy foil layer comprises, for example, 1 to 2.5 g/liter of nickel using nickel sulfate, 0.1 to 1 g/liter of zinc using zinc pyrophosphate, 50 to 500 g/liter of potassium pyrophosphate, bath temperature 20 to 50°C, pH 8 to 11, and current density of 0.3 to 10 A/dm².

The condition for forming a nickel-cobalt alloy foil layer comprises, for example, 80 to 180 g/liter of cobalt sulfate, 80 to 120 g/liter of nickel sulfate, 20 to 40 g/liter of boric acid, 10 to 15 g/liter of potassium chloride, 0.1 to 15 g/liter of sodium dihydrogen sodium phosphate, bath temperature 30 to 50°C, pH 3.5 to 4.5 and current density of 1 to 10 A/dm².

A nickel-phosphorous alloy may be formed using a phosphate based solution of nickel. The condition comprises 120 to 180 g/liter of nickel sulfate, 35 to 55 g/liter of nickel chloride, 30 to 50 g/liter of H₃PO₄, 20 to 40 g/liter of H₃PO₃, bath temperature of 70 to 95°C, pH 0.5 to 1.5 and current density of 5 to 50 A/dm².

The condition for forming a lead-tin alloy foil layer comprises, for example, 20 to 40 g/liter of tin(II) sulfate, 15 to 25 g/liter of lead acetate, 100 to 200 g/liter of sodium pyrophosphate, 15 to 25 g/liter of disodium EDTA, 0.8 to 1.5 g/liter of PEG-3000, 0.3 to 1 ml/liter of 37% aqueous formalin, bath temperature of 45 to 55°C, pH 8 to 10, and current density of 5 to 20 A/dm².

The condition for forming an iron-nickel-cobalt alloy foil layer comprises 50 to 300 g/liter of cobalt sulfate, 50 to 300 g/liter of nickel sulfate, 50 to 300 g/liter of iron(II) sulfate, 30 to 50 g/liter of boric acid, bath temperature of 45 to 55°C, pH 4 to 5, and current density of 1 to 10 A/dm².

A layer structure is formed by repeatedly applying the plating solutions as hitherto described in the metal foil with carrier manufactured by bonding a carrier foil and a metal foil via an organic adhesive interface layer, wherein the metal foil layer has a layer structure comprising two or more of nickel, tin, cobalt, chromium, lead, iron and zinc according to the second aspect of the present invention.

The thin film of the metal layer can be uniformly and smoothly formed by electrodeposition by allowing the carrier film itself to polarize as a cathode, after disposing an anode electrode parallel to the surface of the carrier foil on which an organic adhesive interface is formed using the solutions as hitherto described.

An anti-corrosion treatment is applied on the metal foil, if necessary. The anti-corrosion treatment is applied by plating using a metal having a higher ionization potential than that of the metal foil.

### DESCRIPTION OF THE PREFERRED EMBODIMENTS

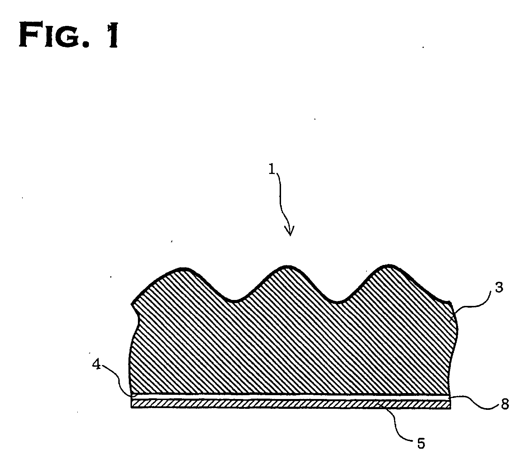

Embodiments of the present invention will be described hereinafter by means of the results of evaluation of peeling properties at the organic adhesive interface while describing the method for manufacturing the metal foil with carrier. The metal foil with carrier using the electrodeposited copper foil as a carrier foil, or the embodiments considered to be optimum among the embodiments in the present invention, will be mainly described herein with reference to Fig. 1.

### Example 1

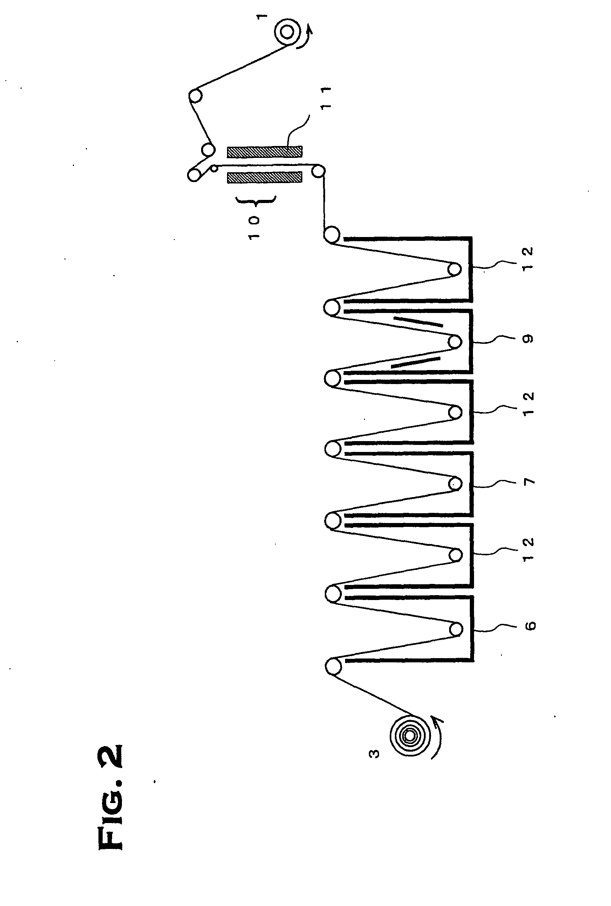

The method for manufacturing the nickel foil 1 with carrier will be described in this example. The manufacturing apparatus 2 is shown in Fig. 2, wherein a unwound carrier foil 3 meanders through the process machine. A drum foil classified into grade No. 3 with a thickness of 18 µm was used for the carrier foil 3, and a nickel foil 5 was formed on a shiny side 4 of the carrier foil 3. The manufacturing conditions will be described below in the order of various kinds of baths continuously arranged in series.

The unwound carrier foil 3 first enters in a pickling bath 6. The pickling bath is filled with a dilute sulfuric acid solution with a concentration of 150 g/liter at a bath temperature of 30°C. Oil components adhered on the carrier foil 3 was removed by immersing the carrier foil in the solution for 30 seconds, followed by removing surface oxide films.

The carrier foil 3 coming out of the pickling bath 6 then enters an adhesive interface forming bath 7. The bath 7 is filled with an aqueous solution containing 5 g/liter of carboxybenzotriazole (CBTA) at a bath temperature of 40°C and pH 5. Accordingly, the running carrier foil 3 was dipped in the solution for 30 seconds, thereby forming a CBTA adhesive interface layer 8 on the surface of the carrier foil 3.

The nickel foil was successively formed on the adhesive interface after forming the CBTA adhesive interface layer 8. The nickel foil 5 was uniformly and smoothly formed by electrodeposition on the adhesive interface while the carrier foil 3 was passing through a nickel-foil-forming bath 9, wherein the carrier foil 3 was polarized as a cathode and electrodeposited in the nickel-foil-forming bath under a condition of 20 g/liter of nickel using nickel sulfate, bath temperature of 40°C, pH 3, and current density of 10 A/dm².

After completely forming the nickel foil layer 5, the carrier foil 3 was finally passed through a drying furnace 10 heated with an electric heater within 40 seconds. The completed nickel foil 1 with carrier was wound. Rinsing baths 12 capable of rinsing with water for about 10 seconds are provided between the two adjoining plating baths in order to prevent contamination of the solution with the solution in the foregoing processing step.

A peel strength at the adhesive interface 8 between the carrier foil layer 3 and the nickel foil layer 5 of the metal foil with carrier 1 was measured. The result showed that the peel strength is 10 gf/cm.

### Example 2

The cobalt foil 1 with carrier in this embodiment was manufactured by replacing the nickel layer forming bath 9 with a cobalt-layer-forming bath 9. Accordingly, descriptions of overlapped portions are omitted since the same drawing as used in Example 1 can be also used in this example. The reference numeral 9 used for the nickel-foil-layer-forming bath, the reference numeral 1 used for the nickel foil with carrier, and the reference numeral 5 used for the nickel foil in the drawing in Example 1 are also used for the cobalt foil layer forming bath, the cobalt foil with carrier, and the cobalt foil, respectively, in this example. Other common reference numerals are also used in this example.

The electrodeposition condition in the cobalt foil layer forming bath 9 comprises 15 g/liter of cobalt using cobalt sulfate, 200 g/liter of trisodium citrate, bath temperature of 35°C, pH 3 and current density of 8 A/dm². The cobalt foil layer 5 with a thickness of 2 µm was uniformly and smoothly electrodeposited on the adhesive interface while the carrier foil 3 was passing through the cobalt foil layer forming bath 9.

The peel strength at the adhesive interface 8 between the carrier foil layer 3 of the cobalt foil 1 with carrier and the cobalt foil layer 5 was measured, obtaining a peel strength of 15 gf/cm.

### Example 3

The tin foil 1 with carrier was manufactured in this example using a tin-foil-layer-forming bath 9 in place of the nickel-foil-layer-forming bath 9 in Example 1. Accordingly, descriptions of the overlapping portions are omitted since the same drawings as used in Example 1 can be also used in this example. The reference numeral 9 used for the nickel-foil-layer-forming bath, the reference numeral 1 used for the nickel foil with carrier, and the reference numeral 5 used for the nickel foil layer in the drawing in Example 1 are also used for the tin-foil-layer-forming bath, the tin foil with carrier, and the tin foil layer, respectively, in this example. The other common reference numerals in Example 1 are also used in this example.

The electrodeposition condition in the tin-foil-layer-forming bath 9 comprises 20 g/liter of tin using tin(II) sulfate, bath temperature of 30°C, pH 3 and current density of 5 A/dm². The tin foil layer 5 with a thickness of 2 µm was uniformly and smoothly electrodeposited on the adhesive interface while the carrier foil 3 was passing through the tin foil layer forming bath 9.

The peel strength at the adhesive interface 8 between the carrier foil layer 3 of the tin foil 1 with carrier and the tin foil layer 5 was measured, obtaining a peel strength of 15 gf/cm.

### Example 4

The lead foil 1 with carrier was manufactured in this example using a lead foil forming bath 9 in place of the nickel-foil-forming bath 9 in Example 1. Accordingly, descriptions of the overlapping portions are omitted since the same drawings as used in Example 1 can be also used in this example. The reference numeral 9 used for the nickel-foil-layer-forming bath, the reference numeral 1 used for the nickel foil with carrier, and the reference numeral 5 used for the nickel foil layer in the drawing in Example 1 are also used for the lead-foil-layer-forming bath, the lead foil with carrier, and the lead foil layer, respectively, in this example. The other common reference numerals in Example 1 are also used in this example.

The electrodeposition condition in the lead-foil-layer-forming bath 9 comprises 350 g/liter of lead borofluoride, 40 g/liter of hydrogen borofluoric acid, 20 g/liter of boric acid, 0.3 g/liter of glue, 0.6 g/liter of betanaphthol, bath temperature of 40°C, and current density of 5 A/dm². The lead foil layer 5 with a thickness of 2 µm was uniformly and smoothly electrodeposited on the adhesive interface while the carrier foil 3 was passing through the tin-foil-layer-forming bath 9.

The peel strength at the adhesive interface between the carrier foil layer 3 of the lead foil 1 with carrier and the lead foil layer 5 was measured, obtaining a peel strength of 12 gf/cm.

### Example 5

The iron foil 1 with carrier was manufactured in this example using a iron-foil-layer-forming bath 9 in place of the nickel-foil-forming bath 9 in Example 1. Accordingly, descriptions of the overlapping portions are omitted since the same drawings as used in Example 1 can be also used in this example. The reference numeral 9 used for the nickel-foil-layer-forming bath, the reference numeral 1 used for the nickel foil with carrier, and the reference numeral 5 used for the nickel foil layer in the drawing in Example 1 are also used for the iron-foil-layer-forming bath, the iron foil with carrier, and the iron foil layer, respectively, in this example. The other common reference numerals in Example 1 are also used in this example.

The electrodeposition condition in the iron-foil-layer,-forming bath 9 comprises 30 g/liter of iron using iron (II) sulfate, bath temperature of 35°C, pH 2.0 and current density of 10 A/dm². The iron foil layer 5 with a thickness of 2 µm was uniformly and smoothly electrodeposited on the adhesive interface while the carrier foil 3 was passing through the iron-foil-layer-forming bath 9.

The peel strength at the adhesive interface 8 between the carrier foil layer 3 of the iron foil 1 with carrier and the iron foil layer 5 was measured, obtaining a peel strength of 12 gf/cm.

### Example 6

The zinc-nickel alloy foil 1 with carrier was manufactured in this example using a zinc-nickel-alloy-foil-layer-forming bath 9 in place of the nickel-foil-layer-forming bath 9 in Example 1. Accordingly, descriptions of the overlapping portions are omitted since the same drawings as used in Example 1 can be also used in this example. The reference numeral 9 used for the nickel-foil-layer-forming bath, the reference numeral 1 used for the nickel foil with carrier, and the reference numeral 5 used for the nickel foil layer in the drawing in Example 1 are also used for the zinc-nickel-alloy-foil-layer-forming bath, the zinc-nickel alloy foil with carrier, and the zinc-nickel alloy foil layer, respectively, in this example. The other common reference numerals in Example 1 are also used in this example.

The electrodeposition condition in the zinc-nickel-alloy-foil-layer-forming bath 9 comprises 2.0 g/liter of nickel using nickel sulfate, 0.5 g/liter of zinc using zinc pyrophosphate, 250 g/liter of potassium pyrophosphate, bath temperature of 35°C, pH 10 and current density of 5 A/dm². The zinc-nickel alloy foil layer 5 with a thickness of 2 µm was uniformly and smoothly electrodeposited on the adhesive interface while the carrier foil 3 was passing through the zinc-nickel-alloy-foil-layer-forming bath 9.

The peel strength at the adhesive interface 8 between the carrier foil 3 of the zinc-nickel alloy foil 1 with carrier and the zinc-nickel alloy foil layer 5 was measured, obtaining a peel strength of 12 gf/cm.

### Example 7

The nickel-cobalt alloy foil 1 with carrier was manufactured in this example using a nickel-cobalt-alloy-foil-layer-forming bath 9 in place of the nickel-foil-layer-forming bath 9 in Example 1. Accordingly, descriptions of the overlapping portions are omitted since the same drawings as used in Example 1 can be also used in this example. The reference numeral 9 used for the nickel-foil-layer-forming bath, the reference numeral 1 used for the nickel foil with carrier, and the reference numeral 5 used for the nickel foil layer in the drawing in Example 1 are also used for the nickel-cobalt alloy foil layer forming bath, the nickel-cobalt alloy foil with carrier, and the nickel-cobalt alloy foil layer, respectively, in this example. The other common reference numerals in Example 1 are also used in this example.

The electrodeposition condition in the nickel-cobalt-alloy-foil-layer-forming bath 9 comprises 130 g/liter of cobalt sulfate, 100 g/liter of nickel sulfate, 30 g/liter of boric acid, 12.5 g/liter of potassium chloride, 8 g/liter of sodium dihydrogen phosphate, bath temperature of 40°C, pH 4.0 and current density of 7 A/dm². The nickel-cobalt alloy foil layer 5 with a thickness of 2 µm was uniformly and smoothly electrodeposited on the adhesive interface while the carrier foil 3 was passing through the nickel-cobalt-alloy-foil-layer-forming bath 9.

The peel strength at the adhesive interface between the carrier foil layer 3 of the nickel-cobalt alloy foil 1 with carrier and the nickel-cobalt alloy foil layer 5 was measured, obtaining a peel strength of 11 gf/cm.

### Example 8

The lead-tin alloy foil 1 with carrier was manufactured in this example using a lead-tin-alloy-foil-layer-forming bath 9 in place of the nickel-foil-layer-forming bath in Example 1. Accordingly, descriptions of the overlapping portions are omitted since the same drawings as used in Example 1 can be also used in this example. The reference numeral 9 used for the nickel-foil-layer-forming bath, the reference numeral 1 used for the nickel foil with carrier, and the reference numeral 5 used for the nickel foil layer in the drawing in Example 1 are also used for the lead-tin-alloy-foil-layer-forming bath, the lead-tin alloy foil with carrier, and the lead-tin alloy foil layer, respectively, in this example. The other common reference numerals in Example 1 are also used in this example.

The electrodeposition condition in the lead-tin-alloy-foil-layer-forming bath 9 comprises 30 g/liter of tin(II) sulfate, 20 g/liter of lead acetate, 150 g/liter of sodium pyrophosphate, 20/liter of disodium EDTA, 1.2 g/liter of PEG-3000, 0.7 ml/liter of 37% aqueous formalin, bath temperature of 50°C, pH 9, and current density of 12 A/dm². The lead-tin alloy foil 5 with a thickness of 2 µm was uniformly and smoothly electrodeposited on the adhesive interface while the carrier foil 3 was passing through the lead-tin-alloy-foil-layer-forming bath 9.

The peel strength at the adhesive interface 8 between the carrier foil layer 3 of the lead-tin alloy foil 1 with carrier and the lead-tin alloy foil layer 5 was measured, obtaining a peel strength of 13 gf/cm.

### Example 9

The iron-nickel-cobalt alloy foil 1 with carrier was manufactured in this example using an iron-nickel-cobalt-alloy-foil-layer-forming bath 9 in place of the nickel-foil-layer-forming bath 9 in Example 1. Accordingly, descriptions of the overlapping portions are omitted since the same drawings as used in Example 1 can be also used in this example. The reference numeral 9 used for the nickel-foil-layer-forming bath, the reference numeral 1 used for the nickel foil with carrier, and the reference numeral 5 used for the nickel foil layer in the drawing in Example 1 are also used for the iron-nickel-cobalt-alloy-foil-layer-forming bath 9, the iron-nickel-cobalt alloy foil 1 with carrier, and the iron-nickel-cobalt alloy foil layer, respectively, in this example. The other common reference numerals in Example 1 are also used in this example.

The electrodeposition condition in the iron-nickel-cobalt-alloy-foil-layer-forming bath 9 the comprises 150 g/liter of cobalt sulfate, 150 g/liter of nickel sulfate, 150 g/liter of iron(II) sulfate, 40/liter of boric acid, bath temperature of 50°C, pH 4.5 and current density of 8 A/dm². The iron-nickel-cobalt foil 5 with a thickness of 2 µm was uniformly and smoothly electrodeposited on the adhesive interface while the carrier foil 3 was passing through the iron-nickel-cobalt-alloy-foil-layer-forming bath 9.

The peel strength at the adhesive interface between the carrier foil 3 of the iron-nickel-cobalt alloy foil 1 with carrier and the iron-nickel-cobalt alloy foil layer 5 was measured, obtaining a peel strength of 12 gf/cm.

### Example 10

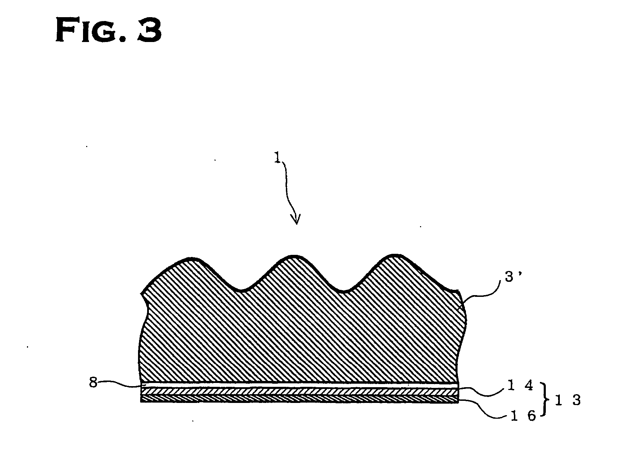

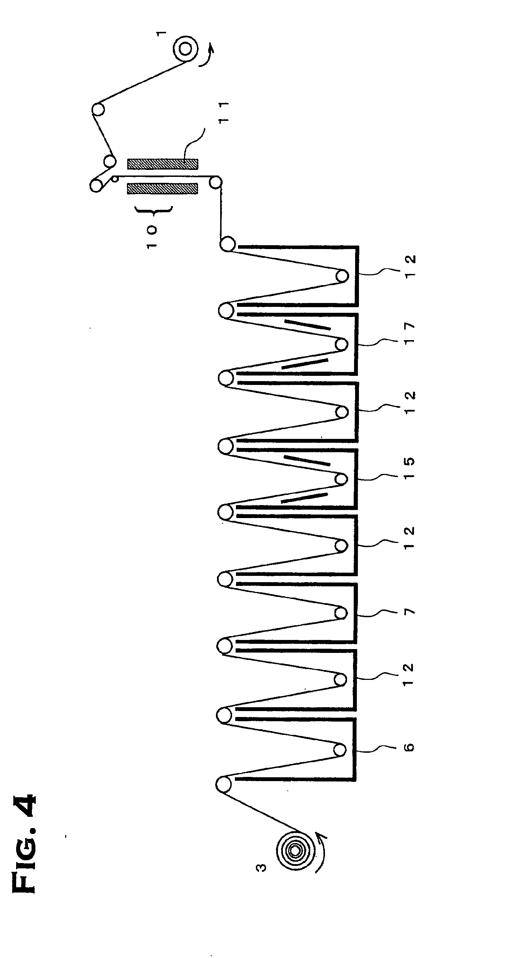

A product having a metal foil with carrier was manufactured in this example, wherein the metal foil portion shown in Fig. 3 comprises a layered structure of a nickel layer and an iron layer. This product is referred to as a nickel/iron foil with carrier 1 hereinafter. The manufacturing apparatus 2' of this product is shown in Fig. 4, in which the carrier foil 3 that has been unwound meanders through the process machine. A drum foil with a thickness of 18 µm classified into grade 3 was used for the carrier foil 3, and the nickel/iron foil layer 13 with a thickness of 4 µm was formed on the shiny side 4 of the carrier foil 3. Overlapping descriptions with those in Example 1 are omitted herein, and only different portions are explained in this embodiment. The same common reference numerals are also used in this example so long as possible.

No modifications are made on the manufacturing steps and conditions before the pickling bath 6 and the adhesive interface forming bath 7 as well as the nickel layer forming bath 15 for forming the nickel layer 14 thereafter. An iron-layer-forming bath 17 is used in order to form an iron layer 16 on a nickel layer on the carrier foil 3 having the nickel layer 14, after uniformly and smoothly electrodepositing the nickel layer 14 with a thickness of 2 µm on the adhesive interface on the surface of the carrier foil 3.

The carrier foil 3 is polarized as a cathode for electrodeposition under a condition comprising 40 g/liter of iron using iron(II) sulfate, bath temperature of 35°C, pH 2.0 and current density of 10 A/dm². An iron layer 16 with a thickness of 2 µm was uniformly and smoothly electrodeposited while the carrier foil 3 passed through the iron-layer-forming bath 17.

The drying step applied hereinafter is the same as that described in Example 1. The peel strength at the adhesive interface 8 between the carrier foil layer 3 of the nickel/iron foil with carrier 1 and the nickel/iron foil layer 13 was measured, obtaining a peel strength of 10 gf/cm.

### EFFECT OF THE INVENTION

Peeling of the carrier foil layer from the metal foil layer can be certainly effected at the interface between them with a small force in the metal foil with carrier according to the present invention. Obtaining such features made it possible for everyone to casually treat various metal foils that had required great care for handling them. Moreover, thin films can be easily formed by forming an organic adhesive interface on the surface of the carrier foil, in addition to forming the metal foil layer by electrodeposition, thereby enabling a variety of layer structures comprising different kinds of plural metals to be formed.

## Claims

1. A metal foil with carrier manufactured by bonding a carrier foil layer and a metal foil layer via an organic adhesive interface layer,
wherein the metal foil layer comprises either one of nickel, tin, cobalt, chromium, lead, iron and zinc, or an alloy as a combination of two or more of them.

2. A metal foil with carrier manufactured by bonding a carrier foil layer and a metal foil layer via an organic adhesive interface layer,
wherein the metal foil layer has a layer structure of two or more of nickel, tin, cobalt, chromium, lead, iron and zinc.

3. A metal foil with carrier according to claim 1 or 2,
wherein the organic adhesive interface layer is formed using one or plural compounds selected from nitrogen containing organic compounds, sulfur containing organic compounds and carboxylic acids.

4. A method for manufacturing metal foil with carrier a according to claims 1 to 3, wherein an organic adhesive interface layer is formed on the surface of the carrier foil, and a metal foil layer is formed on the organic adhesive interface layer by electrodeposition.
